# EUROPÄISCHE PATENTSCHRIFT

(11) **EP 0 459 156 B1**
(45) Veröffentlichungstag und Bekanntmachung des Hinweises auf die Patenterteilung: **02.08.1995**
(21) Anmeldenummer: 91106838.5
(22) Anmeldetag: 26.04.1991
(51) Int. Cl.: H01L 39/02, H01R 4/68

(54) **Verfahren zur Herstellung einer supraleitenden Verbindung von Nb3SN- und NbTi-Leitern und supraleitende Verbindung**
Method for manufacturing a superconducting connection of Nb3Sn and NbTi cables and superconducting connection
Procédé pour la fabrication d'un raccord supraconducteur de câbles en Nb3Sn et NbTi et raccord supraconducteur

(30) Priorität: 31.05.1990 DE 4017553
(43) Veröffentlichungstag der Anmeldung: 04.12.1991
(73) Patentinhaber: Forschungszentrum Karlsruhe GmbH, 76133 Karlsruhe (DE)
(72) Erfinder: Hehn, Werner, Dr., W-7512 Rheinstetten (DE); Schneider, Theo, Dr., W-6729 Wörth 2 (DE); Turowski, Peter, Dr., W-7514 Eggenstein-Leopoldshafen (DE)
(74) Vertreter: Gottlob, Peter, Dipl. Ing.

(56) Entgegenhaltungen:
- EP-A- 0 130 442
- DE-A- 1 927 454
- DE-A- 3 413 167
- IEEE TRANSACTIONS ON MAGNETICS, Bd. 25, Nr. 2, März 1989, NEWYORK US, Seiten 1767 - 1770; J.E.C. WILLIAMS ET AL: '600 MHZ spectrometer magnet'
- REVIEW OF SCIENTIFIC INSTRUMENTS, Bd. 50, Nr. 12, Dezember 1979, NEW YORK US, Seiten 1651-1652; J.T. BROACH ET AL: 'Soldering multifilamentary Nb3Sn conductors'

## Beschreibung

Die Erfindung betrifft ein Verfahren zur Herstellung einer supraleitenden Verbindung von Nb₃Sn- und NbTi-Leitern, das von einem unreagierten Nb₃Sn-Leiter ausgeht und eine supraleitende Verbindung gemäß dem Oberbegriff von Anspruch 8.

Aus der DE-OS 34 13 167 ist ein Verfahren bekannt, mit dem ein supraleitender Kontakt zwischen zwei A15-Leitern, etwa zwischen zwei Nb₃Sn-Leitern, hergestellt werden kann. Bei diesem Verfahren, das ebenfalls von unreagierten Leitern ausgeht, werden die freigelegten Leiterenden zusammen mit einem Pulvergemisch in eine Hülse eingelegt. Das Pulvergemisch besteht im Falle eines Nb₃Sn-Leiters aus Nb-Pulver und Pulver aus Zinn oder Kupfer-Zinn-Bronze. Danach wird die Hülse an beiden Enden druck- und temperaturfest abgedichtet und der Leiter zusammen mit den in der Hülse befindlichen Leiterenden einer Wärmebehandlung zur Bildung des supraleitenden Materials, also einer Reaktionsglühung, unterzogen.

Das Verfahren geht, wie erwähnt, von einer Verbindung von zwei A15-Leitern aus; die Herstellung einer supraleitenden Verbindung eines A15-Leiters, insbesondere eines Nb₃Sn-Leiters, mit einem Supraleiter eines anderen Typs ist nach diesem Verfahren nicht möglich.

In der Veröffentlichung von J.E.C. Williams et al in IEEE Transactions on Magnetics, Vol. 25, No. 2, März 1989, Seiten 1767 bis 1770 wird die Herstellung von supraleitenden Verbindungen zwischen Niob-Zinn- und Niob-Titan-Leitern beschrieben.

Das Ende des unreagierten Niob-Zinn-Drahtes wird in der Weise angeätzt, daß etwa 1 mm der Niob-Filamente freiliegen. Das freigelegte Ende wird in ein enges Bohrloch geschoben, das in einen aus Pulver der Zusammensetzung 90 % Nb und 10 % Zinn gepreßten Block eingebracht wurde.

Nach der Reaktionsglühung wird die Oberfläche des Blocks poliert.

Die Niob-Titan-Leiter werden flachgedrückt und durch ein CVD-Band aus Niob-Zinn auf Hastelloy hindurch auf der Oberfläche des Blocks durch Punktschweißen befestigt. Die Oberflächen der Materialien werden durch Epoxy-Harz gegen Oxidation geschützt.

Mit diesem Verfahren können zwar supraleitende Verbindungen mit kritischen Strömen über 200 A bis 3 T hergestellt werden. Das Verfahren erfordert jedoch einen hohen feinmechanischen Aufwand.

Aufgabe der Erfindung ist, ein einfacheres Verfahren zur Herstellung einer supraleitenden Verbindung zwischen Nb₃Sn- und NbTi-Leitern, bei dem Verbindungen mit derselben Stromtragfähigkeit (> 200 A bei 3 T) erzielt werden und eine supraleitende Verbindung vorzuschlagen.

Die Aufgabe wird erfindungsgemäß gelöst durch ein Verfahren mit den Merkmalen des ersten Patentanspruchs. Die Unteransprüche geben bevorzugte Ausgestaltungen dieses Verfahrens an.

Die erfindungsgemäße supraleitende Verbindung weist die kennzeichnenden Merkmale des Anspruchs 8 auf.

Die unreagierten Nb₃Sn-Leiter enthalten ein oder mehrere Nb-Filamente, die in eine CuSn-Matrix eingebettet sind. Die Matrix ist von einer Diffusionssperre, etwa aus Tantal umgeben. Die äußere Umhüllung wird durch Kupfer gebildet.

Einen ähnlichen Aufbau weisen die NbTi-Leiter auf; auch sie sind von einer Kupferhülle umgeben.

Neben den binären Nb₃Sn-Leitern kommen gelegentlich auch ternäre Nb₃Sn-Leiter zur Anwendung, die z. B. einen Tantal- oder Titan-Anteil in der Größenordnung von einigen Prozent aufweisen. Die Erfindung erstreckt sich auch auf solche ternären Leiter.

Zur Herstellung der supraleitenden Verbindung wird mindestens eines der Nb-Filamente des unreagierten Nb₃Sn-Leiters freigelegt. Vorzugsweise wird der Leiter schräg angeschnitten und die Schnittfläche mit einer Beizlösung aus Flußsäure, Salpetersäure und Wasser behandelt. Nach dieser Behandlung stehen die Nb-Filamente etwa 0,1 mm vor; wegen des schräg angeschnittenen Leiters können sie in den nachfolgenden Schritten einen besonders festen Kontakt herstellen.

Das freigelegte Nb-Filament wird nun in ein Pulver bestehend aus 1 bis 3 % Cu, 5 bis 20 % Sn, Rest Nb eingebettet. Gute Ergebnisse werden mit einem Pulver der Zusammensetzung 88,9 % Niob, 9,82 % Sn und 1,28 % Cu erzielt. Die Einbettung erfolgt am besten in der Nut eines Edelstahlkörpers, in der es mit einem passenden Stempel zu einem festen, auch das Nb-Filament umfassenden Block gepreßt werden kann.

Wesentlich für den Erfolg der weiteren Verfahrensschritte ist, daß der Teil der Oberfläche des Blocks, an dem der Kontakt mit dem NbTi-Leiter hergestellt werden soll, mit einer Folie aus CuSn, bevorzugt mit 13 Gew.-% Sn, bedeckt wird. Diese Folie soll gewährleisten, daß sich bei der nachfolgenden Reaktionsglühung ausreichend Nb₃Sn an den Nb-Körnern auf der vorgesehenen Kontaktfläche des Blocks bilden kann.

Anschließend wird in üblicher Weise, etwa bei 700° C/100 Stunden, die Reaktionsglühung durchgeführt.

Bevorzugt wird die Reaktionglühung jedoch in der Weise durchgeführt, daß der aus Pulver gepreßte Block und die Folie durch eine Preßvorrichtung unter Druck stehen.

Nach der Reaktionsglühung wird die restliche CuSn-Folie auf der vorgesehenen Kontaktfläche entfernt. Dies kann durch Abätzen mit Salpetersäure erfolgen. Danach ist das bei der Reaktionsglühung gebildete Nb₃Sn an der Oberfläche des Blocks offen und sauber zugänglich.

Nun kann das ebenfalls sauber gebeizte NbTi-Filament mit der Kontaktfläche verbunden werden.

Dies geschieht dadurch, daß das NbTi-Filament mit einem deformierbaren Metallstempel auf die Oberfläche des Blocks aufgepreßt wird, so daß der Block, das NbTi-Filament und der Metallstempel eine feste Verbindung eingehen.

Vorzugsweise besteht der deformierbare Metallstempel aus Kupfer; er wird mit Hilfe einer Preßvorrichtung auf das Filament und den Block gedrückt.

Vorteilhafterweise wird ein deformierbarer Metallstempel einer solchen Fläche eingesetzt, daß außer der Kontaktfläche und dem darauf liegenden NbTi-Filament auch ein Teil der Umhüllung des Nb₃Sn-Leiters und/oder des NbTi-Leiters abgedeckt wird. In diesem Fall kann der deformierte Metallstempel mit der (den) Umhüllung(en) verlötet werden, wodurch die elektrische Stabilisierung der Verbindungsstelle und ihre mechanische Festigkeit erheblich verbessert werden.

Durch das erfindungsgemäße Verfahren kann ein starrer Nb₃Sn-Leiter mit einem flexiblen NbTi-Leiter supraleitend verbunden werden.

Es versteht sich von selbst, daß auch Leiter, die mehrere Filamente aufweisen, mit dem erfindungsgemäßen Verfahren in analoger Weise verbunden werden können.

Die Vorteile des erfindungsgemäßen Verfahrens und der danach hergestellten supraleitenden Verbindung liegen in folgenden Eigenschaften:

Durch die verwendete CuSn-Folie wird eine ebene Kontaktfläche mit gut ausgebildeten Nb₃Sn-Kristallen an der Oberfläche erhalten. Der Kontakt zwischen Nb₃Sn und NbTi wird durch einfaches mechanisches Aufpressen der NbTi-Filamente auf die NbSn-Oberfläche hergestellt. Der Kontakt läßt sich mit mäßigen Verlusten an Stromtragfähigkeit mehrmals erneuern.

Die Erfindung wird im folgenden anhand eines Durchführungsbeispiels näher erläutert.

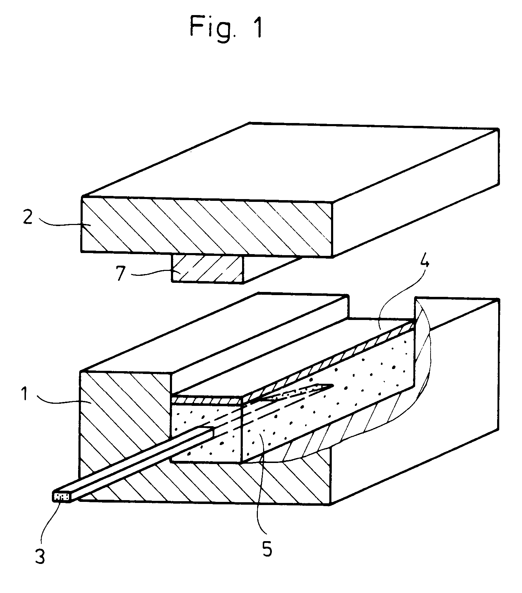

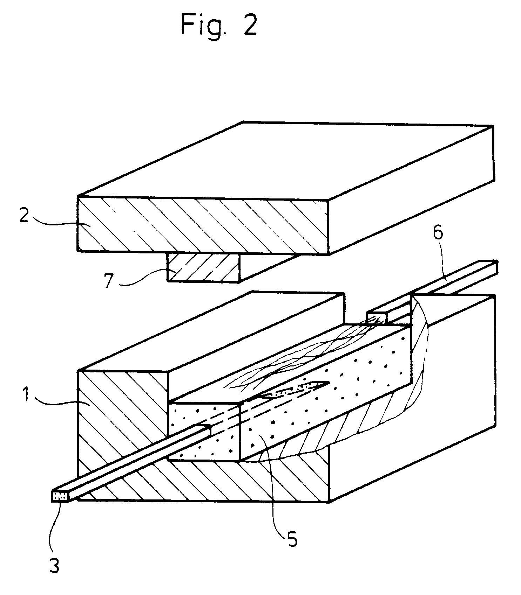

Die Fig. 1 und 2 demonstrieren den Verfahrensablauf.

Die Anordnung zur Herstellung der Verbindung des Nb₃Sn- und NbTi-Leiters besteht aus einem Edelstahlkörper 1, der eine Nut zur Aufnahme der zu kontaktierenden Komponenten aufweist.

Mit Hilfe einer Deckplatte 2 mit einem Steg 7 aus Kupfer, der in die Nut eingreift, können die erforderlichen Druckkräfte aufgebracht werden.

Die Nut des Edelstahlkörpers 1 nimmt das Nb/Sn/Cu-Pulver mit der abdeckenden Folie 4 bzw. - nach der Reaktionsglühung - den daraus entstehenden Nb₃Sn-Pulverkörper 5 auf. In diesen Pulverkörper sind der Nb₃Sn-Supraleiter 3 eingebettet und die NbTi-Filamente des NbTi-Supraleiters 6 aufgepreßt.

### 1. Schaffung eines kontaktfähigen Nb₃Sn-Leiterendes

In die gesäuberte Nut wird eine Schicht Nb/Sn/Cu-Pulvergemisch eingebracht, die nach dem Pressen mit 15 t ca. 0,2 mm dick ist. Dann wird der am Ende einseitig auf ca. 15 mm angeschrägte, unreagierte Nb₃Sn-Multifilamentleiter, z. B. ein HNST 23000 mit 1.73 x 1.15 mm² Querschnitt, so eingelegt, daß dieser Bereich etwa in der Mitte des ca. 45 mm langen Pulverkontaktes liegt. Hiermit wird erreicht, daß der Nb₃Sn-Leiter fest im NbSn-Pulverkörper eingebettet ist. Ein wesentliches Merkmal ist die Präparation des angeschrägten Leiterendes, an dem sich zunächst ein supraleitender Übergang aus dem Multifilamentleiter in den NbSn-Körper bildet. Durch kurzzeitiges Anätzen mit Salpeter- und Flußsäure werden die Filamente auf der schrägen Ebene auf ca. 0.1 mm Länge freigelegt und gesäubert. Beim weiteren Auffüllen der Nut mit Pulvergemisch und dem abwechselnden Kompaktieren mit ca. 15 t kommen alle Filamente mit dem Pulvergemisch in Berührung. Nachdem sich über dem Leiter eine 0.1 bis 0.2 mm dicke Pulverschicht gebildet hat, wird eine 0.15 mm dicke CuSn-Folie aufgelegt und ebenfalls mit ca. 15 t aufgepreßt. Der gesamte Pulverkörper wird durch eine geeignete, aufgeschraubte Deckplatte unter Druck gesetzt und dann zur Bildung von Nb₃Sn bei 700° C ca. 100 h geglüht.

### 2. Präparation der eigentlichen supraleitenden Verbindung

Nach dem Glühen wird die CuSn-Folie mit Salpetersäure abgeätzt und die Nb₃Sn-Kontaktfläche mit einem Gemisch aus Salpetersäure und Flußsäure sauber gebeizt. Der NbTi-Leiter für die zweite Kontakthälfte wird in der Weise präpariert, daß zunächst die Filamente aus der Matrix herausgeätzt und miteinander verflochten werden. Vor dem Auflegen der NbTi-Filamente auf die Nb₃Sn-Kontaktflächen werden diese auch mit einer Beizlösung aus Salpetersäure und Flußsäure gereinigt. Das NbTi-Filamentbündel wird dann auf die Nb₃Sn-Kontaktfläche aufgelegt und über ein weichgespültes Kupferstück mittels einer Deckplatte und Schrauben aufgepreßt. Das Kupferstück ist so ausgebildet, daß der NbTi-Leiter daran aus Gründen der elektrischen und mechanischen Stabilität festgelötet werden kann. In der beschriebenen Weise wurden Kontakte zwischen Nb₃Sn- und NbTi-Leitern hergestellt, die z. B. bei 3 T Ströme von 500 A trugen mit Übergangswiderständen von kleiner als 10⁻¹² Ω.

## Patentansprüche

1. Verfahren zur Herstellung einer supraleitenden Verbindung von Nb₃Sn- und NbTi-Leitern, das von einem unreagierten Nb₃Sn-Leiter ausgeht, mit den Verfahrensschritten
a) mindestens ein Nb-Filament des unreagierten Nb₃Sn-Leiters (3) wird freigelegt,
b) das freigelegte Nb-Filament wird in ein Pulver, bestehend aus 1 bis 3 % Cu, 5 bis 20 % Sn, Rest Nb, eingebettet,
c) das Pulver wird zusammen mit dem freigelegten Filament zu einem festen Block (5) verdichtet,
d) auf mindestens einem Teil der Oberfläche des Blocks wird eine Folie (4) aus CuSn aufgepreßt,
e) der unreagierte Nb₃Sn-Leiter (3) und der feste Block (5) mit der aufgepreßten CuSn-Folie (4) wird einer Reaktionsglühung unterworfen,
f) die restliche CuSn-Folie (4) wird unter Bildung einer Kontaktfläche entfernt,
g) mindestens ein NbTi-Filament des NbTi-Leiters (6) wird freigelegt,
h) das freigelegte NbTi-Filament wird mit Hilfe eines Metallstempels (7) in der Weise auf die Kontaktfläche aufgepreßt, daß der feste Block (5), das NbTi-Filament des NbTi-Leiters (6) und der Metallstempel (7) eine feste Verbindung eingehen.

2. Verfahren nach Anspruch 1, dadurch gekennzeichnet, daß zur Freilegung von mindestens einem Filament gemäß Schritt a) oder g) der Leiter schräg angeschnitten und die Schnittfläche angeätzt wird.

3. Verfahren nach Anspruch 2, dadurch gekennzeichnet, daß das Anätzen gemäß Schritt a) mit einer Beizlösung aus Flußsäure, Salpetersäure und Wasser und gemäß Schritt g) mit Salpetersäure erfolgt.

4. Verfahren nach Anspruch 1, dadurch gekennzeichnet, daß das Pulver aus 88,9 Gew.-% Nb, 9,82 Gew.-% Sn und 1,28 Gew.-% Cu besteht.

5. Verfahren nach Anspruch 1, dadurch gekennzeichnet, daß die Folie aus CuSn 13 Gew.-% Sn enthält.

6. Verfahren nach Anspruch 1, dadurch gekennzeichnet, daß die restliche Folie mit Säure abgeätzt wird.

7. Verfahren nach Anspruch 1, dadurch gekennzeichnet, daß ein Metallstempel mit einer solchen Fläche eingesetzt wird, daß er außer der Kontaktfläche auch einen Teil der Umhüllung des Nb₃Sn-Leiters und/oder des NbTi-Leiters überdeckt und daß die Umhüllung des Leiters mit dem angrenzenden Teil des Metallstempels verlötet wird.

8. Supraleitende Verbindung der Filamente eines Nb₃Sn- und eines NbTi-Leiters (3,6) mit einem Block (5) aus gepreßtem und einer Reaktionsglühung unterworfenem Nb- und Sn-haltigem Pulver, in den die Filamente des Nb₃Sn-Leiters eingebettet sind und auf dessen Oberfläche die Filamente des NbTi-Leiters befestigt sind, dadurch gekennzeichnet, daß mit dem Block und den auf dessen Oberfläche befestigten Filamenten des NbTi-Leiters eine aufgepreßte Schicht (7) eines deformierbaren Metalls in der Weise verbunden ist, daß der Block, die Filamente des NbTi-Leiters und die Schicht des Metalls eine feste Verbindung bilden.

## Claims

1. Method of producing a superconductive connection between Nb₃Sn and NbTi conductors, which is based on an unreacted Nb₃Sn conductor and has the following method steps:
a) at least one Nb filament of the unreacted Nb₃Sn conductor (3) is exposed;
b) the exposed Nb filament is embedded in a powder, comprising 1 to 3 % Cu, 5 to 20 % Sn and the remainder Nb;
c) the powder is compressed, together with the exposed filament, to form a solid block (5);
d) a CuSn film (4) is pressed on at least a portion of the surface of the block;
e) the unreacted Nb₃Sn conductor (3) and the solid block (5) with the pressed-on CuSn film (4) are subjected to a reaction annealing process;
f) the remaining CuSn film (4) is removed so as to form a contact area;
g) at least one NbTi filament of the NbTi conductor (6) is exposed; and
h) the exposed NbTi filament is pressed onto the contact area by means of a metal punch (7) in such a manner that the solid block (5), the NbTi filament of the NbTi conductor (6) and the metal punch (7) form a secure connection.

2. Method according to claim 1, characterised in that, in order to expose at least one filament according to step a) or g), the conductor is inclinedly cut, and the cut face is etched-on.

3. Method according to claim 2, characterised in that the etching-on process of step a) is effected with a mordanting solution of hydrofluoric acid, nitric acid and water, and the etching-on process of step g) is effected with nitric acid.

4. Method according to claim 1, characterised in that the powder comprises 88.9 % by wt. Nb, 9.82 % by wt. Sn and 1.28 % by wt. Cu.

5. Method according to claim 1, characterised in that the CuSn film contains 13 % by wt. Sn.

6. Method according to claim 1, characterised in that the remaining film is etched-off with acid.

7. Method according to claim 1, characterised in that a metal punch is used and has such a face that, in addition to the contact area, it also covers a portion of the covering of the Nb₃Sn conductor and/or of the NbTi conductor, and in that the covering of the conductor is soldered to the adjacent portion of the metal punch.

8. Superconductive connection of the filaments of a Nb₃Sn conductor (3) and of a NbTi conductor (6) to a block (5) formed from pressed Nb- and Sn-containing powder, which is subjected to a reaction annealing process, the filaments of the Nb₃Sn conductor being embedded in said block, and the filaments of the NbTi conductor being secured on the surface of said block, characterised in that a pressed-on layer (7) of a deformable metal is connected to the block and the filaments of the NbTi conductor, which are secured on the surface of said block, in such a manner that the block, the filaments of the NbTi conductor and the layer of metal form a secure connection.

## Revendications

1. Procédé pour la fabrication d'un raccord supraconducteur de conducteurs ou câbles en Nb₃Sn et en NbTi, qui part d'un conducteur en Nb₃Sn n'ayant pas réagi, avec les étapes de procédé :
a) au moins un filament de Nb du conducteur (3) en Nb₃Sn n'ayant pas réagi est mis à nu,
b) le filament de Nb mis à nu est enrobé dans une poudre, se composant de 1 à 3 % de Cu, 5 à 20 % de Sn, le reste de Nb,
c) la poudre est comprimée conjointement avec le filament mis à nu en un bloc solide (5),
d) sur au moins une partie de la surface du bloc est appliquée par pression une feuille (4) en CuSn,
e) le conducteur (3) en Nb₃Sn n'ayant pas réagi et le bloc solide (5) avec la feuille (4) en CuSn comprimée est soumis à un recuit réactionnel,
f) la feuille (4) de CuSn résiduelle est éliminée en formant une surface de contact,
g) au moins un filament de NbTi du conducteur (6) en NbTi est mis à nu,
h) le filament en NbTi mis à nu est comprimé à l'aide d'un poinçon en métal (7) sur la surface de contact de manière, que le bloc solide (5), le filament en NbTi du conducteur (6) en NbTi et le poinçon métallique (7) procurent un raccord solide.

2. Procédé selon la revendication 1, caractérisé en ce que pour la mise à nu d'au moins un filament selon l'étape a) ou l'étape g) le conducteur est coupé en biais et la surface de coupe est traitée par corrosion.

3. Procédé selon la revendication 2, caractérisé en ce que la corrosion selon l'étape a) a lieu avec une solution de décapage d'acide fluorhydrique, d'acide nitrique et d'eau et selon l'étape g) avec de l'acide nitrique.

4. Procédé selon la revendication 1, caractérisé en ce que la poudre est composée de 88,9 % en poids de Nb, 9,82 % en poids de Sn et 1,28 % en poids de Cu.

5. Procédé selon la revendication 1, caractérisé en ce que la feuille de CuSn contient 13 % en poids de Sn.

6. Procédé selon la revendication 1, caractérisé en ce que la feuille résiduelle est éliminée par corrosion avec de l'acide.

7. Procédé selon la revendication 1, caractérisé en ce qu'un poinçon métallique est mis en oeuvre avec une surface telle, qu'il recouvre en dehors de la surface de contact également une partie de la gaine du conducteur en Nb₃Sn et/ou du conducteur en NbTi et en ce que la gaine du conducteur est brasée avec la partie adjacente du poinçon métallique.

8. Raccord supraconducteur des filaments d'un conducteur (3) en Nb₃Sn et d'un conducteur (6) en NbTi avec un bloc (5) en une poudre comprimée contenant du Nb et du Sn soumise à un recuit réactionnel, bloc dans lequel sont enrobés les filaments du conducteur en Nb₃Sn, et sur la surface duquel sont fixés les filaments du conducteur en NbTi, caractérisé en ce qu'avec le bloc et les filaments du conducteur NbTi fixés à sa surface, est reliée une couche comprimée (7) d'un métal déformable, de manière que le bloc, les filaments du conducteur NbTi et la couche de métal forment un raccord fixe.
